Europäisches Patentamt

European Patent Office

Office européen des brevets

(19)

(11) Veröffentlichungsnummer: **0 166 209 B1**

(12) **EUROPÄISCHE PATENTSCHRIFT**

(45) Veröffentlichungstag der Patentschrift: 02.05.91

(51) Int. Cl.⁵: **G01R 19/145**, G01R 15/08

(21) Anmeldenummer: 85106334.7

(22) Anmeldetag: 23.05.85

(54) **Messgerät zur Überprüfung der Schutzmassnahmen in elektrischen Anlagen.**

(30) Priorität: 13.06.84 DE 3421880

(43) Veröffentlichungstag der Anmeldung:
02.01.86 Patentblatt 86/01

(45) Bekanntmachung des Hinweises auf die
Patenterteilung:
02.05.91 Patentblatt 91/18

(84) Benannte Vertragsstaaten:
**AT BE DE FR IT NL SE**

(56) Entgegenhaltungen:
**DE-A- 2 633 786**
**DE-A- 3 130 786**
**US-A- 4 314 312**

**IBM TECHNICAL DISCLOSURE BULLETIN,
Band 19, Nr. 8, Januar 1977, Seiten
2830-2831, New York, US; C.P. LUDEMAN et
al.: "Universal probe point"**

**"de/der elektromeister + deutsches elektrohandwerk", Heft 3/78, Seiten 148 bis 152**

(73) Patentinhaber: **Asea Brown Boveri Aktiengesellschaft
Kallstadter Strasse 1
W-6800 Mannheim-Käfertal(DE)**

(72) Erfinder: **Ziegler, Herbert
Hartensteiner Strasse 66
W-8500 Nürnberg(DE)**
Erfinder: **Hochreuther, Karl
Hersbrucker Strasse 98
W-8500 Nürnberg(DE)**

(74) Vertreter: **Rüpprecht, Klaus, Dipl.-Ing. et al
c/o Asea Brown Boveri Aktiengesellschaft
Zentralbereich Patente Postfach 100351
W-6800 Mannheim 1(DE)**

## Beschreibung

Die Erfindung betrifft ein Meßgerät der im Oberbegriff des Anspruchs 1 genannten Art.

Zur Überprüfung der Schutzmaßnahmen in elektrischen Anlagen ist die Erfassung einer Vielzahl von Meßgrößen erforderlich. Bei der Erstellung geeigneter Meßgeräte für die verschiedenen Prüfungen stehen sich zwei unterschiedliche Konzepte gegenüber. So ist es möglich, mehrere auf besondere Prüfungen spezialisierte Einzelgeräte zu entwickeln oder aber das Meßgerät so zu gestalten, daß möglichst viele Prüfungen mit dem selben Gerät durchgeführt werden können. Es muß darauf geachtet werden, daß der durch ein Konzept der zweiten Art erreichte Vorteil, daß nur ein Gerät an den Einsatzort mitgenommen werden muß, nicht durch eine komplizierte Bedienung zum Teil wieder aufgehoben wird.

Die meisten Prüfungen werden unmittelbar an den Schutzkontaktsteckdosen des Niederspannungsnetzes durchgeführt. Hierzu sind die Meßleitungen des Gerätes mit einem dreipoligen Meßstecker verbunden, der in die Schutzkontaktsteckdosen eingesteckt werden kann. Die Messung selbst erfolgt jedoch nicht dreipolig, sondern nur zweipolig, d.h. von den drei aus Schutzkontakt und zwei Steckerstiften bestehenden Polen des Meßsteckers werden nur zwei als Meßkontakte benötigt, die Potentialdifferenzen zwischen bestimmten Leitern des Netzes aufnehmen. Je nach Art der zu ermittelnden Meßgröße muß zwischen dem Phasenleiter L und dem Schutzleiter PE oder zwischen dem Phasenleiter L und dem Null-Leiter N gemessen werden. Da vor der Messung nicht bekannt ist, an welcher der beiden Buchsen einer Steckdose der Phasenleiter liegt, muß dessen Lage bei herkömmlichen Meßgeräten zunächst durch eine Phasenprüfung festgestellt werden. Danach ist der Meßstecker entsprechend der an seinen Polen vorgesehenen Kennzeichnung richtig einzustecken. Obwohl die Messung im Prinzip zweipolig durchgeführt wird, müssen bei den meisten bekannten Geräten dennoch alle drei Pole angeschlossen werden, da die Stromversorgung dieser Geräte über das Netz erfolgt.

Die Überprüfung der Schutzmaßnahmen beschränkt sich nicht nur auf Steckdosen, sondern muß selbstverständlich auch in Anlagen unmittelbar an den Leitern durchführbar sein. Dabei ist der dreipolige Meßstecker für die Kontaktierung ungeeignet, so daß er bei bekannten Meßgeräten durch drei Meßleitungen mit Bananensteckern ersetzt oder über einen Adapter mit diesen verbunden wird. Hierbei ist wiederum störend, daß bei den drei Bananensteckern genau auf die Polarität geachtet werden muß.

Zur Ermittlung einer Meßgröße, z.B. des Netz-Schleifenwiderstandes sowie des daraus resultierenden Kurzschlußstroms, sind nacheinander mehrere Einzelmessungen durchzuführen, bei denen das Meßgerät bedient werden muß. Zur Bedienung sind, wie bei dem in "de/der elektromeister + deutsches elektrohandwerk" Heft 3/78, Seite 148 bis 152 beschriebenen Isolationsmeßgerät, mehrere Schalter oder Taster erforderlich. Für eine Einzelperson ist es aber nun nicht oder doch nur schwer möglich einerseits die Bananenstecker bzw. Meßspitzen an die Netzleitungen zu halten und andererseits das Meßgerät zu bedienen.

Aufgabe der Erfindung ist es, ein Meßgerät der im Oberbegriff des Anspruchs 1 genannten Art so zu gestalten, daß beim Verbinden der Meßleitungen des Meßgerätes mit der zu untersuchenden elektrischen Anlage nicht auf die Polarität (Phase) geachtet werden muß und die Durchführung der Messung schnell und einfach erfolgen kann, ohne daß während der Messung auf dem Meßgerät vorgesehene Bedienelemente betätigt werden müssen.

Diese Aufgabe wird durch die im Anspruch 1 gekennzeichneten Merkmale gelöst. Weitere Fortbildungen und zweckmäßige Ausgestaltungen der Erfindung sind in den Unteransprüchen genannt.

Da die Meßautomatik dafür sorgt, daß von den drei Polen des Meßsteckers immer die beiden richtigen als Meßkontakte ausgewählt werden, ergibt sich nicht nur der Vorteil, daß beim Einstecken des Meßsteckers in eine Steckdose nicht mehr auf die Phasenlage geachtet werden muß, sondern vor allem auch, daß aus dem Dreipol- nach Belieben ein Zweipolanschluß gemacht werden kann. Für Messungen, bei denen sich der Meßstecker nicht zur Kontaktierung eignet, ist es also nicht erforderlich, drei Meßleitungen mit dem Meßstecker zu verbinden, sondern es genügen zwei Meßleitungen mit angeschlossenen Bananensteckern oder Meßspitzen. Ein weiterer Vorteil des erfindungsgemäßen Meßgerätes ist, daß die Hand nicht mehr vom Meßstecker genommen werden muß, um eine Messung bis zum Ende durchzuführen, sondern daß hierzu die Bewegung eines Fingers zur Betätigung des Handschalters genügt.

Um verschiedene Meßgrößen ermitteln zu können, sorgt die Meßautomatik in Verbindung mit dem Meßgrößenumschalter durch geeignete Umschaltung dafür, daß jeweils der Polstift zum Meßkontakt wird, der an Phase zu liegen kommt, während der am Null-Leiter liegende Polstift oder der Schutzkontakt, ggf. wechselnd als Meßkontakt dienen.

In weiterer Ausgestaltung der Erfindung ist ein auf den Meßstecker aufsetzbarer Kontaktadapter als Stecktopf gestaltet, an dem zwei Meßspitzen befestigt sind. Wichtig ist, daß eine der beiden Meßspitzen mit dem Stecktopf fest verbunden ist, so daß der Meßstecker mit dem aufgesetzten Kontaktadapter in einer Hand gehalten werden kann. Eine zweite Meßspitze des Kontaktadapters ist über ein Meßkabel mit dem Stecktopf verbunden und kann in der anderen Hand gehalten werden. Mit beiden Meßspitzen kann so eine gefahrlose Messung an freien Leitungen erfolgen, wobei die Bedienung des Meßgerätes über den Handschalter erfolgt.

Eine weitere Ausgestaltung des Erfindungsgegenstandes sieht vor, daß man mit dem Meßstecker nicht nur an Steckdosen mit außenliegenden Schutzkontakten messen kann, sondern auch an solchen, die mit einem Schutzkontaktstift versehen sind. Hierdurch ergibt sich auch eine einfache Kontaktierung der auf dem Stecktopf fest montierten Meßspitze, die mit einem Schutzkontaktstift versehen ist, der in eine Schutzkontaktbuchse des Meßsteckers eingreift.

Die durch automatische Umschaltung erzielbare Phasenanpassung ist nicht in allen Fällen von Vorteil. So gibt es Länder in denen Steckdosen mit einem Schutzkontaktstift vorgeschrieben sind, der ein Umpolen des Steckers verhindert. Die Lage der Phase zum Schutzkontaktstift ist vorgeschrieben. Eine automatische Phasenanpassung ist hier unerwünscht, da sie eine Kontrolle der Phasenlage verhindern würde und auch keine Messung zwischen Null-Leiter N und Schutzleiter PE möglich wäre. Es ist deshalb ein Spannungsmeßbereich vorgesehen, bei dem die automatische Phasenanpassung abgeschaltet ist und eine feste und dem Meßstecker gekennzeichnete Polzuordnung gilt. Bei aufgesetztem Kontaktadapter kann man in dieser Stellung des Meßbereichsschalters zwischen allen drei Leitern des Netzes Potentialdifferenzen messen. Durch die Messung der an den Leitern liegenden Potentialdifferenzen läßt sich auch die Lage der Phase ermitteln oder kontrollieren.

Eine weitere Verbesserung der Handhabbarkeit des Meßgerätes wird dadurch erreicht, daß am Meßstecker auch noch ein Berührungskontakt vorgesehen ist. Der Berührungskontakt wird automatisch berührt, sobald man den Meßstecker in die Hand nimmt. Das ist sehr wichtig, da ein gefährliches am Schutzleiter liegendes Potential, aber auch die Lage des Phasenleiters, schon vor Beginn der eigentlichen Messung festgestellt werden kann. Hierzu dient eine Signalschaltung, die über den Berührungskontakt hochohmig mit dem Schutzkontakt des Meßsteckers verbunden ist. Bei einer unzulässigen Potentialdifferenz fließt bei Berührung ein Körperstrom gegen Erde, der die Signalschaltung aktiviert. Der Körperstrom muß selbstverständlich so niedrig wie möglich gehalten werden und darf auch im Fehlerfall keinen bedenklichen Wert erreichen.Diese Voraussetzungen werden durch einen Schutzkondensator, der die Signalschaltung mit dem Berührungskontakt koppelt, gewährleistet, wobei ein Verstärker dafür sorgt, daß Ströme im Mikroamperebereich ausreichen, um die Signalschaltung zu aktivieren. Der Schutzkondensator ist so aufgebaut, daß er die vom Meßgerät eingehaltene Schutzklasse 2 (Prüfspg.4 kV) ebenfalls erfüllt.

Die Versorgung der Signalschaltung aus einer Batterie macht diese netzunabhängig, so daß eine am Schutzleiter liegende gefährliche Spannung auch dann signalisiert werden kann, wenn an Phase keine Spannung liegt. Eine vom Netz gespeiste Signalschaltung, wie sie sonst üblich ist, wäre hierzu nicht in der Lage.

Bei einer zweckmäßigen Ausbildung des Meßgerätes wird der Meßablauf durch den Handschalter initiiert der, auf die, vorzugsweise durch einen Mikroprozessor gesteuerte, Meßautomatik wirkt. Weiterhin sind optische und/oder akustische Signalmittel am Meßgerät vorgesehen, die unzulässige Abweichungen von bestimmten Nennbedingungen, unter denen die Messung durchzuführen ist, insbesondere unzulässige Netzspannungen, signalisieren.

Zweckmäßigerweise wird der Handschalter als Taster ausgebildet und die durch Betätigen der Taste initiierte Einschaltung des Meßgerätes auf eine durch eine Zeitschaltung begrenzte Zeit, vorzugsweise 15 Sekunden, beschränkt.

Eine Ausbildung des Handschalters als Schiebetaster, der außer seiner Ruhestellung und einer zweiten Stellung für das Einschalten des Meßgerätes eine dritte Schaltstellung besitzt, erlaubt es in dieser Stellung weitere Auswertungen oder Prüfungen vorzunehmen, die je nach Stellung des Meßgrößenumschalters wechseln können. Außerdem ist das Meßgerät vorteilhaft so aufgebaut, daß die automatische Abschaltung nach ca. 15 s nicht wirksam wird, wenn der Handschalter erneut in seine dritte Schaltstellung gebracht wird. Hierdurch verlängert sich die Einschaltzeit um jeweils ca. 15 s.

Vorteilhaft ist es, wenn das Meßgerät in der dritten Schaltstellung des Handschalters einen Rechenwert anzeigt, der von dem mit der zweiten Schaltstellung ermittelten Meßwert durch eine Rechenschaltung des Meßgerätes mathematisch abgeleitet wird. Dieser Rechenwert wäre z.B. der Kurzschlußstrom, wenn der Meßgrößenumschalter eine zur Messung des Schleifenwiderstandes oder des Innenwiderstandes vorgesehene Schaltstellung einnimmt.

Es ist weiterhin möglich die dritte Schaltstellung des Handschalters dahingehend zu nutzen, daß über die beiden Meßkontakte ein Prüfstrom fließt, der etwa dem Nennfehlerstrom eines zu prüfenden Fehlerstromschutzschalters entspricht, wenn der Meßgrößenumschalter eine zur Messung der Berührungsspannung vorgesehene Schaltstellung einnimmt.

Eine Messung des Erdungswiderstandes ist durch das Spannungsabsenkungsverfahren möglich, aber besser noch durch Verwendung einer Erdsonde durchführbar. Eine vorteilhafte Weiterbildung des erfindungsgemäßen Meßgerätes sieht deshalb eine Buchse zum Anschließen einer Erdsonde vor.

Die Buchse enthält einen Umschaltkontakt, der einen Meßkontakt vom Meßstecker an die Erdsonde legt, so daß der für die Spannungsmessung frei gewordene Pol des Meßsteckers nur zum Leiten des Prüfstroms dient. Ein Ausführungsbeispiel des erfindungsgemäßen Meßgerätes wird im folgenden näher beschrieben und in den Zeichnungen dargestellt.

Es zeigen:

Figur 1: Den Aufbau des erfindungsgemäßen Meßgerätes.

Figur 2: Ein Blockschaltbild des Meßgerätes.

Figur 3: Die Anwendung des Meßgerätes bei der FI-Schalterprüfung.

Figur 4: Die Anwendung des Meßgerätes bei der Messung des Erdungswiderstandes.

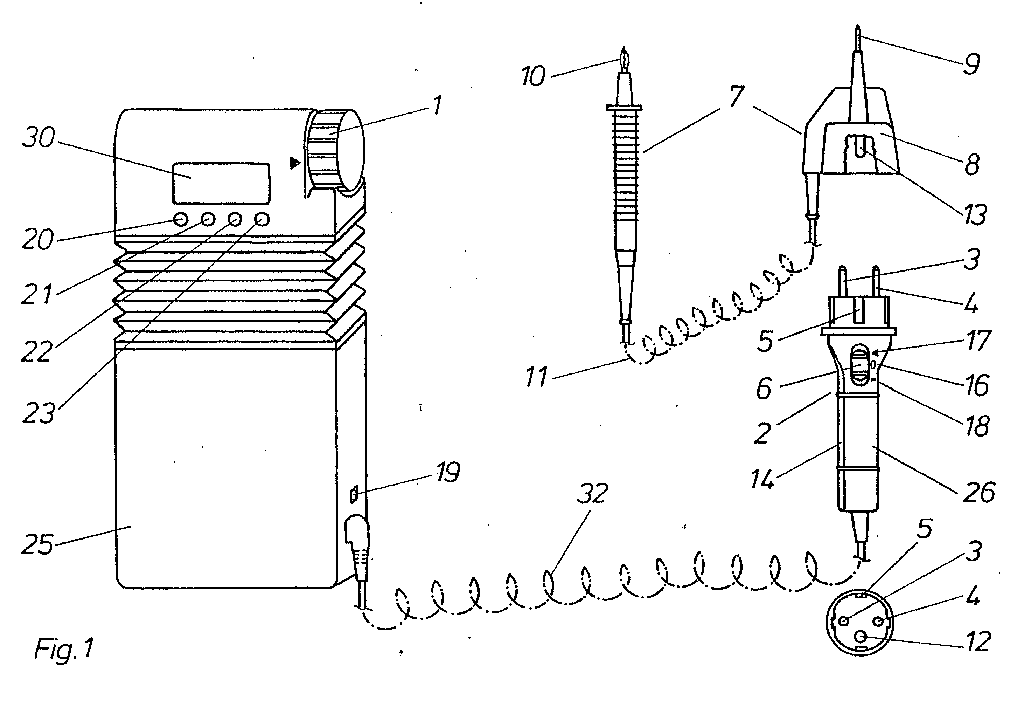

Wie Figur 1 zeigt, besteht das Meßgerät aus einem Gehäuse 25, in dem die wichtigsten Funktionseinheiten untergebracht sind, einem Meßstecker 2 und einem auf diesen aufsteckbaren Kontaktadapter 7. Am Gehäuse 25 sind ein Meßgrößenumschalter 1, eine Buchse 19 zum Anschließen einer Erdsonde, Leuchtdioden 20 bis 23 zum Signalisieren bestimmter Fehlerzustände und ein Display 30 zur Anzeige bestimmter Meß- oder Rechenwerte vorgesehen.

Der Meßstecker 2 ist über Meßleitungen 32 mit den im Gehäuse 25 untergebrachten Funktionseinheiten verbunden. Er ist an seinem kontaktierten Ende entsprechend einem genormten Schutzkontaktstecker ausgebildet und besitzt drei Pole 3 bis 5. Zwei der Pole sind als Polstifte 3,4 und ein Pol als Schutzkontakt 5 ausgeführt. Der entsprechend der deutschen Norm außenliegende Schutzkontakt 5 ist mit einer Schutzkontaktbuchse 12 verbunden, wie sie in anderen Ländern bei Schutzkontaktsteckern vorgeschrieben ist. Ein den Meßstecker 2 verlängernder Handgriff 26 trägt einen Schiebetaster 6, der drei Schaltstellungen 16 bis 18 besitzt. Die mittlere Stellung des Tasters 6 ist seine Ruhestellung 16, in die er nach Betätigung zurückkehrt. Wird der Taster 6 in seine zweite, vorne liegende Stellung 17 gebracht, so wird das Meßgerät eingeschaltet und seine Meßautomatik tritt in Aktion. Die automatisch ermittelte und digital auf dem Display 30 angezeigte Meßgröße richtet sich nach der Schaltstellung des Meßgrößenumschalters und der somit vorgewählten Meßgröße oder Meßart. Sollten die bei der Messung einzuhaltenden Randbedingungen nicht erfüllt sein, so signalisieren die Leuchtdioden 20 bis 23 den jeweiligen Fehler oder Mangel.

Da das Meßgerät, um es unabhängig vom Netz zu machen, batteriebetrieben ist, wird die Einschaltzeit des Gerätes durch eine Abschaltautomatik auf eine Dauer von 15 Sekunden begrenzt. Bringt man jedoch den Taster 6 in seine dritte Stellung 18, bevor sich das Gerät selbsttätig abgeschaltet hat, so verlängert sich die Einschaltdauer um weitere 15 Sekunden. Das Meßgerät bleibt so lange eingeschaltet, solang der Taster in seiner dritten Stellung 18 gehalten wird. Weiterhin ist das Meßgerät so ausgelegt, daß es in der dritten Stellung 18 des Tasters 6 zusätzliche Meß- oder Rechenfunktionen ausführt, die im allgemeinen in Verbindung mit der vorher in der zweiten Stellung 17 des Tasters 6 durchgeführten Messung stehen.

Da sich der Meßstecker 2 zur Messung an nicht genormten Steckdosen oder frei liegenden Leitungen nicht eignet, ist ein Kontaktadapter 7 vorgesehen, der sich auf den Meßstecker aufsetzen läßt. Der Kontaktadapter 7 besitzt zur Aufnahme des Meßsteckers 2 einen Stecktopf 8, an dem eine erste Meßspitze befestigt ist sowie eine über ein Meßkabel 11 mit dem Stecktopf 8 verbundene zweite Meßspitze 10. Die Kontakte im Stecktopf 8 sind so gelegt, daß über einen Kontaktstift 13, der beim Zusammenstecken auf die Schutzkontaktbuchse 12 trifft, eine Verbindung des Schutzkontaktes PE mit der ersten Meßspitze 9 erfolgt. Ein weiteres Kontaktstück verbindet einen der beiden Steckerstifte 3,4 über das Meßkabel 11 mit der zweiten Meßspitze 10.

Auf einer Seite des zum Meßstecker 2 gehörigen Handgriffs 26 ist ein Berührungskontakt 14 angebracht, der über die Hand und den Körper des Berührenden Erdpotential an das Meßgerät legt. Der Berührungskontakt 14 ist der eine Pol eines Schutzkondensators, der zusammen mit einem Verstärker im Handgriff 26 eingebaut ist und geringste Ströme, die vom Schutzleiter PE über den Berührungskontakt 14 gegen Erde fließen, erfaßt und zur Signalisierung an eine der Leuchtdioden 20 bis 23 meldet. Die Schaltung ist so ausgelegt, daß sich bereits vor dem Einschalten der Meßautomatik und somit vor der eigentlichen Messung, gefährliche Berührungsspannungen am Schutzleiter PE oder die Lage der Phase ermitteln lassen.

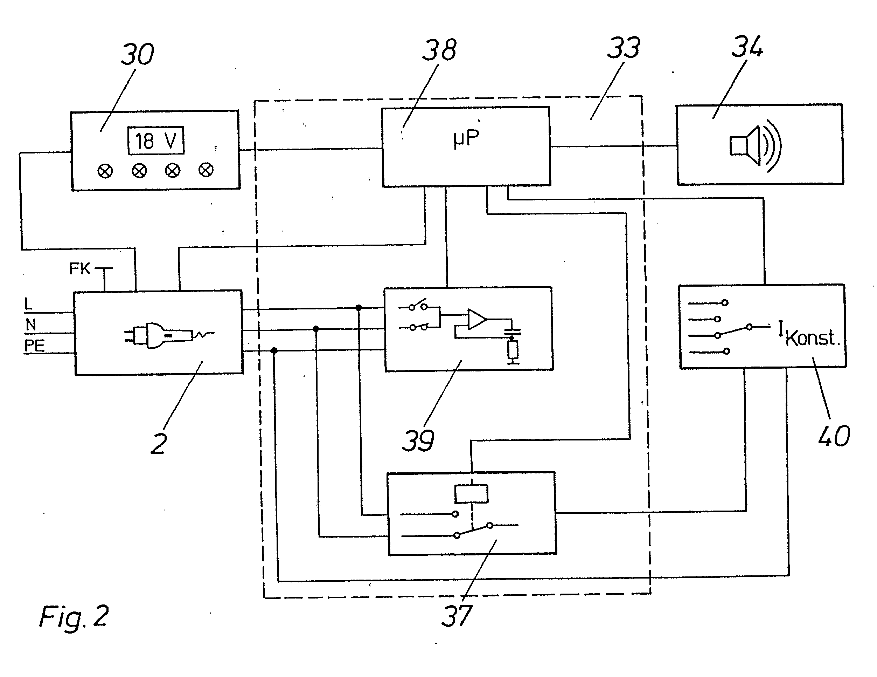

In Figur 2 ist ein Blockschaltbild des Meßgerätes dargestellt, mit dessen Hilfe sich grob das Zusammenwirken der einzelnen Baugruppen erläutern läßt. Der Meßstecker 2 wird beim Einstecken in eine Schutzkontaktdose mit dem Phasenleiter L, dem Null-Leiter N und dem Schutzleiter PE verbunden. Ein Fingerkontakt FK dient als Berührungskontakt, zur Schaffung eines netzexternen Erdpotentials. Die Auswahl der Meßgröße, die zunächst am Meßgrößenumschalter 1 vorgegeben wird, erfolgt durch die Meßautomatik 33. Ein Mikroprozessor 38 übernimmt dabei alle Steuer- und Rechenfunktionen. Für die richtige Polarität bzw. Lage der Phase am Eingang der Meßautomatik 33 sorgt eine Phasenanpaßautomatik 37.

Da die Berührungsspannung, der Schleifenwiderstand und der Netzinnenwiderstand nach dem Prinzip der Spannungsabsenkung gemessen werden, muß diese durch eine entsprechende Belastung des Netzes herbeiführbar sein. Hierzu dient eine Konstantstromquelle 40, die das Netz mit einem konstanten Strom belastet. Zur Überprüfung von FI-Schutzschaltern ist der Konstantstrom mit Hilfe des Meßgrößenumschalters auf verschiedene Werte einstellbar. Die bei der Spannungsabsenkung entstehende Differenzspannung wird über einen Integrator 39 ermittelt.

Die jeweilige Meß- oder Rechengröße wird über eine Anzeigeeinheit ausgegeben und auf einem Display 30 digital dargestellt. Fehlerzustände werden durch Leuchtdioden signalisiert. Das Ablesen der Meßgröße auf dem Display 30 läßt sich bisweilen dadurch vermeiden, daß ein akustischer Signalgeber 34 deutlich hörbar signalisiert, wenn die Meßgröße im vorgeschriebenen Bereich liegt.

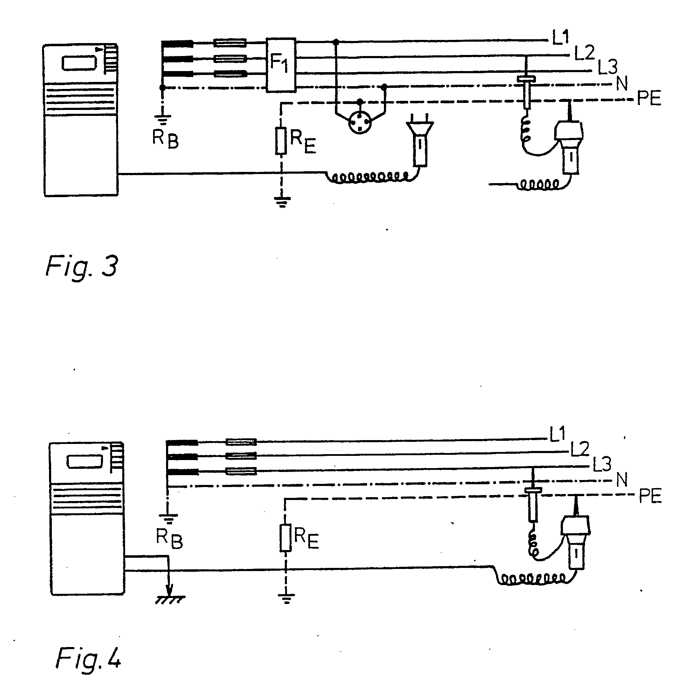

Die Figuren 3 und 4 verdeutlichen nochmal die Möglichkeiten, die sich beim Anschließen des Meßgerätes am Netz ergeben. Nach Figur 3 wird ein FI-Schalter auf seine Funktionsfähigkeit überprüft, während nach Figur 4 ein Erdungswiderstand gemessen wird. In beiden Fällen ist sowohl eine Messung mit dem unmittelbar in eine Steckdose einsteckbaren Meßstecker, wie auch mit dem auf den Meßstecker aufgesetzten Kontaktadapter möglich. Der Kontaktadapter gestattet in vorteilhafter Weise eine Zweipolmessung. Bei beiden Messungen kann mit oder ohne Erdsonde gearbeitet werden. Wird mit Erdsonde gearbeitet, wie in Figur 4 dargestellt, so kommt nicht die Spannungsabsenkung sondern das Prinzip der Strom/SpannungsMessung zur Anwendung.

**Ansprüche**

1. Meßgerät zur Überprüfung der Schutzmaßnahmen in elektrischen Anlagen durch Ermittlung verschiedener, über einen Meßgrößenschalter (1) wählbarer Meßgrößen, mit einem entsprechend einem Schutzkontaktstecker gestalteten dreipoligen Meßstecker (2), dessen drei aus Schutzkontakt (5) und zwei Steckerstiften (3,4) bestehende Pole über Meßleitungen (32) mit dem Meßgerät verbunden sind, von denen aber jeweils höchstens zwei, ggf. wechselnde Pole, als Meßkontakte zur Aufnahme von für die jeweilige Messung benötigten Potentialdifferenzen dienen, sowie mit einer Meßautomatik (33) und mit einem Handschalter (6) dadurch gekennzeichnet, daß die Meßautomatik (33) in Abhängigkeit von der Stellung des Meßgrößenumschalters (1) und der sich beim Einstecken des Meßsteckers (2) an eine Steckdose ergebenden Polung ggf. durch Umschalten bestimmt, welche der drei Pole (3,4,5) des Meßsteckers (2) als Meßkontakte wirken, und der am Meßstecker (2) angebrachte Handschalter (6) so über die Meßautomatik mit dem Meßgrößenumschalter (1) zusammenwirkt, daß nach dessen Einstellung auf die jeweilige Meßgröße, die weitere Bedienung des Meßgerätes nur über den Handschalter (6) erfolgt.

2. Meßgerät nach Anspruch 1, dadurch gekennzeichnet, daß die Meßautomatik durch geeignete Umschaltung jeweils den Polstift (3 oder 4) zum Meßkontakt macht, der an Phase (L) zu liegen kommt, während der am Null-Leiter (N) liegende Polstift (4 oder 3) oder der Schutzkontakt (5), ggf. wechselnd, als Meßkontakt dienen.

3. Meßgerät nach Anspruch 1 oder 2, dadurch gekennzeichnet, daß ein auf den Meßstecker (2) aufsetzbarer Kontaktadapter (7) aus einem Stecktopf (8) besteht, an dem zwei Meßspitzen (9,10) befestigt sind, wobei eine erste, auf dem Stecktopf (8) fest montierte Meßspitze (9) mit dem Schutzkontakt (5) des Meßsteckers (2) kontaktiert und eine zweite, über ein Meßkabel (11) mit dem Stecktopf (8) verbundene Meßspitze mit einem der beiden Polstifte (3,4) des Meßsteckers (2) kontaktiert.

4. Meßgerät nach einem der vorhergehenden Ansprüche, dadurch gekennzeichnet, daß der Meßstecker (2) neben den äußeren Schutzkontakten (5) auch eine Schutzkontaktbuchse (12) zur Aufnahme eines Schutzkontaktstiftes besitzt und die Kontaktierung der ersten Meßspitze (9) des Kontaktadapters (7) über einen Kontaktstift (13) erfolgt, der in die Schutzkontaktbuchse (12) eingreift.

5. Meßgerät nach einem der Ansprüche 1 bis 4, dadurch gekennzeichnet, daß am Meßgrößenumschalter (1) zwei Meßbereiche zur Spannungsmessung vorgesehen sind und in einem ersten Meßbereich die beiden Polstifte (3,4) als Meßkontakte dienen, so daß die Spannung zwischen Phasenleiter L und Null-Leiter N gemessen wird während in einem zweiten Meßbereich ein Polstift und der Schutzkontakt als Meßkontakte dienen und hierbei unter Mitwirkung der automatischen Phasenanpassung zwischen dem Phasenleiter L und dem Schutzleiter PE gemessen wird.

6. Meßgerät nach Auspruch 5, dadurch gekennzeichnet, daß die automatische Phasenanpassung der Polstifte (3,4) in der Stellung des Meßgrößenumschalters, die zur Messung der Spannung zwischen Phase L und Schutzleiter PE vorgesehen ist, gesperrt ist und der Meßstecker mit Polbezeichnungen versehen ist, die eine definierte Zuordnung zur Lage der Phase an der Steckdose ermöglichen.

7. Meßgerät nach einem der vorhergehenden Ansprüche, dadurch gekennzeichnet, daß am Meßstecker (2) ein Berührungskontakt (14) vorgesehen ist, der hochohmig, vorzugsweise mit einem Schutzkondensator kapazitiv, über eine Signalschaltung mit dem Schutzkontakt (5) des Meßsteckers (2) verbunden ist, derart, daß bei einer gefährlichen am Schutzleiter liegenden Potential bei Berührung des Berührungskontaktes (14) ein Körperstrom gegen Erde fließt, der die Signalschaltung zur Signalisierung des zu hohen PE-Potentials veranlaßt.

8. Meßgerät nach Anspruch 7, dadurch gekennzeichnet, daß die Signalschaltung einen Verstärker beinhaltet, und ihre Stromversorgung aus einer Batterie erfolgt, die auch zur Versorgung des Meßgerätes dient.

9. Meßgerät nach einem der vorhergehenden Ansprüche, dadurch gekennzeichnet, daß der Handschalter (6) auf die, vorzugsweise durch einen Mikroprozessor gesteuerte, Meßautomatik wirkt, und dadurch den Meßablauf initiiert und optische und/oder akustische Signalmittel am Meßgerät vorgesehen sind, die unzulässige. Abweichungen von bestimmten Nennbedingungen, unter denen die Messung durchzuführen ist, insbesondere unzulässige Netzspannungen, signalisieren.

10. Meßgerät nach einem der vorhergehenden Ansprüche, dadurch gekennzeichnet, daß der Handschalter (6) als Taster ausgebildet ist, und einen durch Betätigen des Tasters initiierte Einschaltung des Meßgerätes nur eine durch eine Zeitschaltung begrenzte Zeit, vorzugsweise 15 Sekunden, wirksam bleibt, nach der das Meßgerät selbsttätig abschaltet.

11. Meßgerät nach einem der vorhergehenden Ansprüche, dadurch gekennzeichnet, daß der Handschalter (6) als Schiebetaster ausgebildet ist, der außer seiner Ruhestellung (16) und seiner zweiten Stellung (17) für das Einschalten des Meßgerätes, eine dritte Schaltstellung (18) besitzt, die je nach Stellung des Meßgrößenumschalters (1) weitere Auswertungen oder Prüfungen ermöglicht und bei erneuter Betätigung eine Anzeigeverlängerung um 15 Sekunden bewirkt.

12. Meßgerät nach Auspruch 11, dadurch gekennzeichnet, daß in der dritten Schaltstellung (18) des Handschalters (6) das Meßgerät einen Rechenwert anzeigt, der von dem in der zweiten Schaltstellung ermittelten Meßwert durch eine Rechenschaltung des Meßgerätes mathematisch abgeleitet ist und daß dieser Rechenwert der Kurzschlußstrom ist, wenn der Meßgrößenumschalter (1) eine zur Messung des Schleifenwiderstandes oder des Innenwiderstandes vorgesehene Schaltstellung einnimmt.

13. Meßgerät nach Auspruch 11, dadurch gekennzeichnet, daß in der dritten Schaltstellung (18) des Handschalters (6) auf die beiden Meßkontakte ein Prüfstrom fließt, der etwa dem Nennfehlerstrom eines zu prüfenden Fehlerstromschutzschalters entspricht, wenn der Meßgrößenumschalter (1) eine zur Messung der Berührungsspannung vorgesehene Schaltstellung einnimmt.

14. Meßgerät nach einem der vorhergehenden Ansprüche, dadurch gekennzeichnet, daß das Meßgerät eine Buchse (19) zum Anschließen einer Erdsonde besitzt und die Buchse (19) einen Umschaltkontakt enthält, der einen Meßkontakt vom Meßstecker (2) an die Erdsonde legt, so daß der für die Spannungsmessung frei gewordene Pol des Meßsteckers nur zum Leiten des Prüfstroms dient.

## Claims

1. Measuring instrument for checking the protective measures in electrical installations by determining different measurands which can be selected via a measurand changeover switch (1), having a three-pole measuring plug (2), which is configured in accordance with an earthing-pin plug and whose three poles, which consist of an earthing contact (5) and two plug pins (3,4), are connected via measuring lines (32), to the measuring instrument, of which, however, in each case at most two, possibly alternating poles serve as measuring contacts for picking up potential differences required for the respective measurement, as well as having automatic measuring equipment (33) and a manual switch (6), characterised in that, depending upon the position of the measurand changeover switch (1) and the polarity produced upon insertion of the measuring plug (2) into a socket outlet, the automatic measuring equipment (33) determines, possibly by switching over, which of the three poles (3,4,5) of the measuring plug (2) are acting as measuring contacts, and the manual switch (6) mounted on the measuring plug (2) cooperates with the measurand changeover switch (1) via the automatic measuring equipment in such a way that after its setting to the respective measurand further operation of the measuring instrument is effected only via the manual switch (6).

2. Measuring instrument according to Claim 1, characterised in that by switching over appropriately the automatic measuring equipment in each case renders as measuring contact the pole pin (3 or 4) which comes to be connected to phase (L), while the pole pin (4 or 3) connected to the neutral conductor (N), or the earthing contact (5) serve, possibly alternately, as measuring contact.

3. Measuring instrument according to Claim 1 or 2, characterised in that a contact adaptor (7) that can be mounted on the measuring plug (2) consists of a plug-in pot (8) to which two measuring tips (9,10) are fastened, a first measuring tip (9) mounted fixed on the plug-in pot (8) being in contact with the earthing contact (5) of the measuring plug (2), and a second measuring tip connected to the plug-in pot (8) via a measuring cable (11) being in contact with one of the two pole pins (3,4) of the measuring plug (2).

4. Measuring instrument according one of the preceding claims, characterised in that apart from the external earthing contacts (5) the measuring plug (2) also possesses an earthing socket (12) for receiving an earthing contact pin, and the contacting of the first measuring tip (9) of the contact adaptor (7) is effected via a contact pin (13), which engages in the earthing socket (12).

5. Measuring instrument according to one of Claims 1 to 4, characterised in that two measurement ranges are provided for measuring voltage at the measurand change-over switch (1), and in a first measurement range the two pole pins (3,4) serve as measuring contacts, so that the voltage between a phase conductor L and a neutral conductor N is measured, while in a second measurement range a pole pin and the earthing contact serve as measuring contacts, and in this regard measurement is carried out in conjunction with the automatic phase matching between the phase conductor L and the protective conductor PE.

6. Measuring instrument according to Claim 5, characterised in that the automatic phase matching of the pole pins (3,4) is blocked in the position of the measurand changeover switch that is provided for measuring the voltage between the phase L and protective conductor PE, and the measuring plug is provided with pole markings which enable a defined assignment to the position of the phase on the socket outlet.

7. Measuring instrument according to one of the preceding claims, characterised in that a touch contact (14) is provided at the measuring plug (2) which is connected via a signal circuit to the earthing contact (5) of the measuring plug (2) in a highly resistive fashion, preferably by means of a protective capacitor and in such a way that when a dangerous potential is present on the protective conductor a body current, which causes the signal circuit to signal the excessive PE-potential flows to earth when the touch contact (14) is touched.

8. Measuring instrument according to Claim 7, characterised in that the signal circuit contains an amplifier, and its current supply is effected from a battery, which also serves to supply the measuring instrument.

9. Measuring instrument according to one of the preceding claims, characterised in that the manual switch (6) acts upon the automatic measuring equipment, which is preferably controlled by a microprocessor, and thus initiates the measurement sequence, and optical and/or acoustic signal means are provided at the measuring instrument, which signal impermissible deviations from specific reference conditions under which the measurement is to be carried out, in particular impermissible system voltages.

10. Measuring instrument according to one of the preceding claims, characterised in that the manual switch (6) is constructed as a push button, and a switching-in of the measuring instrument that is initiated by operating the pushbutton remains effective only for a time that is limited by a timing circuit, preferably 15 seconds, after which measuring instrument automatically switches off.

11. Measuring instrument according to one of the preceding claims, characterised in that the manual switch (6) is constructed as a sliding key switch, which apart from its neutral position (16) and its second position (17) for switching in the measuring instrument possesses a third switch position (18) which, depending upon the position of the measurand changeover switch (1) enables further evaluations or tests, and upon renewed operation effects an extension of the display by 15 seconds.

12. Measuring instrument according Claim 11, characterised in that in the third switch position (18) of the manual switch (6) the measuring instrument displays a computed value which is derived mathematically by a computing circuit of the measuring instrument from the measured value determined in the second switch position, and in that said computed value is the short-circuit current, if the measurand changeover switch (1) adopts a switch position provided for measuring the loop impedance or the internal impedance.

13. Measuring instrument according to Claim 11, characterised in that in the third switch position (18) of the manual switch (6) a test current, which corresponds approximately to the nominal fault current of a fault-current circuit breaker to be tested, flows onto the two measuring contacts, if the measurand changeover switch (1) adopts a switch position provided for measuring the touch voltage.

14. Measuring instrument according to one of the preceding claims, characterised in that the measuring instrument possesses a socket (19) for the connection of an earthing probe and the socket (13) contains a change-over contact, which connects a measuring contact of the measuring plug (2) to the earthing probe, so that the pole of the measuring plug that has become free for voltage measurement serves only to conduct the test current.

**Revendications**

1. Appareil de mesure pour le contrôle de la protection dans des installations électriques par détermination de différentes grandeurs de mesure sélectionnables par l'intermédiaire d'un commutateur (1) de grandeur de mesure, comprenant une fiche de mesure (2) tripolaire, réalisée à la manière d'une fiche de sécurité dont les trois pôles constitués du contact de mise à la terre (5) et de deux connecteurs mâles (3, 4) sont reliés, par l'intermédiaire de lignes de mesure (32), à l'appareil de mesure, mais parmi lesquels chaque fois au maximum deux pôles, le cas échéant en alternance, servent de contacts de mesure pour capter les différences de potentiel nécessaires à chaque mesure, et comprenant un système de mesure automatique (33) et un commutateur manuel (6), caractérisé par le fait qu'en fonction de la position du commutateur (1) de grandeur de mesure et de la polarité obtenue lors de l'enfichage de la fiche de mesure (2) dans une prise de courant, le système de mesure automatique (33) détermine, le cas échéant par commutation, lesquels des trois pôles (3, 4, 5) de la fiche de mesure (2) agissent en tant que contacts de mesure, et que le commutateur manuel (6) disposé sur la fiche de mesure (2) coopère, par l'intermédiaire du système de mesure automatique, avec le commutateur (1) de grandeur de mesure de manière telle que, après le réglage de ce dernier sur la grandeur de mesure correspondante, la manipulation ultérieure de l'appareil de mesure s'effectue uniquement par l'intermédiaire du commutateur manuel (6).

2. Appareil de mesure selon la revendication 1, caractérisé par le fait que par une commutation appropriée, le système de mesure automatique fait agir comme contact de mesure chaque fois la fiche polaire (3 ou 4) qui est en liaison avec la phase (L), tandis que la fiche polaire (4 ou 3), en liaison avec le conducteur neutre (N), ou le contact de mise à la terre (5) servent de contact de mesure, le cas échéant en alternance.

3. Appareil de mesure selon la revendication 1 ou 2, caractérisé par le fait qu'un adaptateur de contacts (7) pouvant être rapporté sur la fiche de mesure (2) est constitué d'un godet enfichable (8) sur lequel sont fixées deux touches de mesure (9, 10), une première touche de mesure (9) montée solidaire du godet enfichable (8) étant en contact avec le contact de mise à la terre (5) de la fiche de mesure (2), et une deuxième touche de mesure, qui est reliée par un câble de mesure (11) au godet enfichable (8), étant en contact avec l'une des deux fiches polaires (3, 4) de la fiche de mesure (2).

4. Appareil de mesure selon l'une des revendications précédentes, caractérisé par le fait que la fiche de mesure (2) possède, en plus des contacts de mise à la terre (5) extérieurs, une douille (12) de contact de mise à la terre pour la réception d'une fiche de contact de mise à la terre, et la connexion de la première touche de mesure (9) de l'adaptateur de contacts (7) se fait par l'intermédiaire d'une fiche de contact (13) qui pénètre dans la douille (12) de contact de mise à la terre.

5. Appareil de mesure selon l'une des revendications 1 à 4, caractérisé par le fait que deux plages de mesure pour la mesure de la tension sont prévues sur le commutateur (1) de grandeur de mesure, et que dans une première plage de mesure, les deux fiches polaires (3, 4) servent de contacts de mesure, de manière à mesurer la tension entre le conducteur de phase L et le conducteur neutre N, tandis que dans une deuxième plage de mesure une fiche polaire et le contact de mise à la terre servent de contacts de mesure et qu'une mesure est effectuée entre le conducteur de phase L et le conducteur de protection PE, avec coopération de l'adaptation de phase automatique.

6. Appareil de mesure selon la revendication 5, caractérisé par le fait que dans la position du commutateur de grandeur de mesure qui est prévue pour mesurer la tension entre la phase L et le conducteur de protection PE, l'adaptation de phase automatique des fiches polaires (3, 4) est bloquée, et la fiche de mesure est pourvue de repérages de pôle qui permettent une attribution définie à la position de la phase sur la prise de courant.

7. Appareil de mesure selon l'une des revendications précédentes, caractérisé par le fait que sur la fiche de mesure (2) il est prévu un contact sensitif (14) qui est relié avec une valeur ohmique élevée, de préférence de manière capacitive avec un condensateur de protection, par l'intermédiaire d'un circuit de signalisation, au contact de mise à la terre (5) de la fiche de mesure (2), de manière à ce que, en cas de potentiel dangereux appliqué au conducteur de protection un courant passe du corps vers la terre, lorsqu'on touche le contact sensitif (14), courant qui amène le circuit de signalisation à signaler le potentiel PE trop élevé.

8. Appareil de mesure selon la revendication 7, caractérisé par le fait que le circuit de signalisation comprend un amplificateur et que son alimentation en courant se fait à partir d'une batterie qui sert également à l'alimentation de l'appareil de mesure.

9. Appareil de mesure selon l'une des revendications précédentes, caractérisé par le fait que le commutateur manuel (6) agit sur le système de mesure automatique, commandé de préférence par un microprocesseur, et initialise ainsi le processus de mesure, et qu'il est prévu des moyens de signalisation optiques et/ou acoustiques sur l'appareil de mesure, qui signalent des écarts inadmissibles par rapport à des conditions nominales déterminées dans lesquelles la mesure doit être effectuée, notamment des tensions de secteur inadmissibles.

10. Appareil de mesure selon l'une des revendications précédentes, caractérisé par le fait que le commutateur manuel (6) est réalisé sous forme de touche et une mise sous tension de l'appareil de mesure, initialisée par l'actionnement de la touche, n'est effective que pendant une durée limitée par une minuterie, de préférence pendant 15 secondes, durée après laquelle l'appareil se met automatiquement hors tension.

11. Appareil de mesure selon l'une des revendications précédentes, caractérisé par le fait que le commutateur manuel (6) est réalisé sous forme d'interrupteur à coulisse qui possède, en plus de sa position de repos (16) et de sa deuxième position (17) pour la mise sous tension de l'appareil de mesure, une troisième position de commutation (18) qui, selon la position du commutateur (1) de grandeur de mesure, permet des exploitations ou contrôles supplémentaires et, lors d'un nouvel actionnement, commande la prolongation de l'indication de 15 secondes.

12. Appareil de mesure selon la revendication 11, caractérisé par le fait que dans la troisième position (18) du commutateur manuel (6), l'appareil de mesure indique une valeur de calcul qui est dérivée de la valeur de mesure, déterminée dans la deuxième position du commutateur, mathématiquement par un circuit de calcul de l'appareil de mesure, et que cette valeur de calcul est le courant de court-circuit, lorsque le commutateur (1) de grandeur de mesure occupe une position prévue pour mesurer la résistance de boucle ou la résistance interne.

13. Appareil de mesure selon la revendication 11, caractérisé par le fait que dans la troisième position (18) du commutateur manuel (6), il est appliquée aux deux contacts de mesure un courant de contrôle qui correspond à peu près au courant de défaut nominal d'un disjoncteur à courant de défaut, lorsque le commutateur (1) de grandeur de mesure occupe une position de commutation prévue pour mesurer la tension de contact.

14. Appareil de mesure selon l'une des revendications précédentes, caractérisé par le fait que l'appareil de mesure comporte une douille (19) pour le raccordement d'une sonde de mise à la terre et que la douille (19) comprend un contact de commutation qui relie un contact de mesure de la fiche de mesure (2) à la sonde de mise à la terre, de sorte que le pôle de la fiche de mesure libéré pour la mesure de tension ne sert qu'à la transmission du courant de contrôle.

Fig.1

EP 0 166 209 B1

**Fig. 2**

EP 0 166 209 B1

Fig. 3

Fig. 4